# EUROPEAN PATENT SPECIFICATION

(11) **EP 3 514 556 B1**
(45) Date of publication and mention of the grant of the patent: **16.09.2020**
(21) Application number: 18215713.1
(22) Date of filing: 21.12.2018
(51) Int. Cl.: G01R 31/34

(54) **METHOD AND SYSTEM FOR MAGNETIC BURST TESTING OF ELECTRIC MOTORS**
VERFAHREN UND SYSTEM ZUR MAGNETISCHEN BERSTPRÜFUNG VON ELEKTROMOTOREN
PROCÉDÉ ET SYSTÈME DE TEST DE RAFALE MAGNÉTIQUE DE MOTEURS ÉLECTRIQUES

(30) Priority: 21.12.2017 US 201715849775; 21.12.2017 US 201715849854
(43) Date of publication of application: 24.07.2019
(73) Proprietor: Avo Mutli-Amp Corporation dba Megger, Dallas, TX 75237-1088 (US)
(72) Inventor: Powers, Craig, Fort Collins, CO Colorado 80525 (US)
(74) Representative: EIP

(56) References cited:
- EP-A1- 3 247 036
- US-B1- 6 385 057

## Description

### Technical Field

This invention relates to a method and system for magnetic burst testing of electric motors. More particularly, to a method and system for magnetic burst testing of larger motors with a portable tester powered by a domestic wall outlet.

### Background

There is difficulty in delivering sufficient motor current to test large industrial motors using a portable tester. Prior to this invention, the tester needed to be powered by a two or three phase outlet of 220V or higher. In embodiments of the invention, the tester can run broken rotor bar tests using a single-phase outlet of just 117/120 Volts.

European Patent application EP3247036A1 relates to controlling a sensorless alternating current induction motor (ACIM) having a rotor and a stator comprising a plurality of stator windings by applying a plurality of phase shifted voltages to the plurality of stator windings in the ACIM such that two energized stator windings are connected to first and second phase shifted voltages to cause rotation of the rotor relative to the stator while a third unconnected stator winding is floating so that a DC bus current and an inducted voltage can be measured from the ACIM and used to compute an estimated rotor speed.

### Summary

In accordance with a first aspect of the invention, there is provided a method according to claim 1. In accordance with a second aspect of the invention, there is provided a system according to claim 7.

In embodiments of the invention, there is provided a small portable tester powered from a wall outlet in the 15-20 amperes range to provide sufficient test current (5-10% of nameplate) to test industrial motors of several thousand horsepower for the broken rotor bar defect. In a first aspect, a method for magnetic/impedance burst testing of large electric motors is provided. The method may include providing a portable tester that provides a Signal Processor, a single-phase power source VAC, an AC to DC boost converter connected to the power source, at least one energy storage device connected to the AC to DC boost converter, a pulse width modulated drive (PWM) module connected to the at least one energy storage device, and a series of at least three switches (IPM) using switch/level boost-type PWM rectification, the IPM connected to both the 3 legs of the large electric motor and the PWM drive.

The method may include programming the PWM drive with a desired duration of output burst with the Signal Processor, programming the PWM drive with an initial magnetic test angle with the Signal Processor, programming the PWM drive with a test frequency for magnetic angle reversals with the Signal Processor, programming the Programmable Gain Amplifier with the Signal Processor to optimize the signal gain in order to prevent voltage and current signal clipping, controlling the PWM drive module with the Signal Processor to control the amplitude, magnetic angle and reversal frequency applied to the ACIM, controlling the boost converter with the Signal Processor to limit/throttle the maximum power drawn from the single-phase AC source and the power delivered to the large energy storage device to maximally charge the energy storage device, controlling the series of switches (IPM) with the CCP to prevent crowbar of the DC Buss by adding dead-time to the PWM signals and interlocking out unsafe PWM conditions, controlling the CCP with the PWM drive module to pass through only safe PWM drive conditions, controlling the charging of the at least one energy storage device with the boost converter to a maximum working voltage, sending an enable signal to the PWM drive to begin burst output from the Signal Processor, sampling a stream of measured voltage and/or currents of at least one of the motor legs during burst output with a voltage transducer and a current transducer respectively, which converts from analog to a digital A/D Converter digital number with the A/D Converter, adjusting the PWM drive with the set point level and measured voltage and/or current to maintain a desired burst level in order to compensate for sinking voltage of the at least one energy storage device applied to the programmed voltage and/or current level applied to the motor with the Signal Processor, recording the stream of digital numbers with the Signal Processor, calculating, at the end of each burst, rotor characteristics that include impedance, admittance, instantaneous power, voltage and currents for the previously applied magnetic test angle with the Signal Processor, recharging the at least one energy storage device with the boost converter until the maximum working voltage is attained, advancing the magnetic angle by N degrees to measure the response of each set of rotor bars that are in the line given magnetic angle and verify the response is the same for all magnetic angles with the Signal Processor, repeating the burst test N number of times until a full rotation of magnetic angles are tested and recorded with the Signal Processor, verifying, with the Signal Processor, rotor impedance versus magnetic angle of the full rotation in order to check for failure, and determining failure by identifying a shift in measured stator's impedance/admittance, harmonic or sub-harmonic level for any of the given magnetic angles by the Signal Processor.

In an embodiment of the invention, the system for magnetic/impedance burst testing of large electric motors to determine broken rotor bar defect provides a portable tester and includes a Signal Processor, a single-phase power source VAC, an AC to DC boost converter connected to the power source, at least one energy storage device connected to the AC to DC boost converter, a Pulse Width Modulated drive module (PWM) connected to the at least one energy storage device, and a series of at least three switches (IPM) using switch/level boost-type PWM rectification.

The IPM is connected to both the 3 legs of the large electric motor and the PWM drive. The PWM is programmed with a desired duration of output burst by the Signal Processor, the PWM is programmed with an initial magnetic test angle by the Signal Processor, the PWM is programmed with a test frequency for magnetic angle reversals by the Signal Processor, the programmable Gain Amplifier is programmed by the Signal Processor to optimize the signal gain in order to prevent voltage and current signal clipping, the PWM is controlled by the Signal Processor to control the amplitude, magnetic angle and reversal frequency applied to the ACIM, the boost converter is controlled by the Signal Processor to limit/throttle the maximum power drawn from the single-phase AC source and the power delivered to the large energy storage device to maximally charge the energy storage device.

The series of switches IPM is controlled by the CCP to prevent crowbar of the DC Buss by adding dead-time to the PWM signals and interlocking out unsafe PWM conditions, the CCP is controlled by the PWM drive module to pass through only safe PWM drive conditions, the charging of the at least one energy storage device is controlled by the boost converter to a maximum working voltage, an enable signal to the PWM drive to begin burst output is sent from the Signal Processor, a stream of measured voltage and/or currents of at least one of the motor legs during burst output are sampled with at least one voltage transducer and at least one current transducer respectively, which converts from analog to a digital A/D Converter digital number with the A/D Converter, the PWM drive is adjusted with a set point level and measured voltage and/or current to maintain a desired burst level in order to compensate for sinking voltage of the at least one energy storage device applied to the programmed voltage and/or current level applied to the large electric motors with the Signal Processor.

The stream of digital numbers are stored within the Signal Processor, at the end of each burst, rotor characteristics that include impedance, admittance, instantaneous power (I squared r), voltage and currents for the previously applied magnetic test angle are calculated by the Signal Processor, the at least one energy storage device is recharged by the boost converter until the maximum working voltage is re-attained, the magnetic angle is advanced by N degrees to measure the response of each set of rotor bars that are in the line given magnetic angle and verify the response is the same for all magnetic angles with the Signal Processor, repeating the burst test N number of times until a full rotation of magnetic angles are tested and recorded with the Signal Processor, verifying, with the Signal Processor, rotor impedance versus magnetic angle of the full rotation in order to check for failure. Broken rotor bar defect is determined when a shift in measured stator's impedance/admittance, harmonic or sub-harmonic level for any of the given magnetic angles is identified by the Signal Processor.

An embodiment of the invention further includes using the recorded voltage and current samples to calculate the response of the rotor bars stimulated by the burst pulse for the given magnetic angle setting, harmonics, pulsation, wherein intermittently connected rotor bar defect are identified as well.

In an embodiment of the invention, if the response for a given magnetic angle is different than all the other measured magnetic angles, then the construction of the rotor is not symmetrical, indicating a failure in one of the rotor bar sets probed by the magnetic angle as shown by the deviation from the normalized measurements.

In an embodiment of the invention, the power source is a domestic wall outlet and/or a battery, and wherein the at least one energy storage device is a DC link capacitor and/or battery,
In an embodiment of the invention, the PWM drive with a test frequency for magnetic angle reversals is preferably in the range from 1Hz to 10,000 Hz.

In an embodiment of the invention, the maximum working voltage is required to charge the at least one energy storage device so that the boost converter can supply a power burst up to 8KW.

In an embodiment of the invention, the stimulus burst applied to the stator coils is magnetically coupled to the rotor coil, the response of the rotor coil to the stimulus burst is recorded, and wherein there is a short transient response that dies out in about 2 ½ cycles, which is then followed by a steady state response of the rotor to the burst pulse.

In an embodiment of the invention, in addition to the transformer coupled impedance of the rotor as measured by the stator, the harmonic and sub-harmonic response of the rotor to the burst are measured, and when the magnetic angle of the burst pulse is rotated to probe the rotor bars that the magnetic field passes through.

In an embodiment of the invention, by rotating the magnetic field, different rotor bar sets are probed, and wherein a response of a good rotor bar set responding to a burst pulse at one magnetic field angle simulating them is identified as being different than that of broken rotor bar set probed with the magnetic angle burst pulse that stimulates them instead.

### Brief Description of the Drawings

The subject matter that is regarded as the invention is particularly pointed out and distinctly claimed in the claims at the conclusion of the specification. The foregoing and other features, and advantages of embodiments are apparent from the following detailed description taken in conjunction with the accompanying drawings in which:
Figure 1 illustrates a block diagram of a system for the magnetic burst testing of large electric motors according to the present invention,

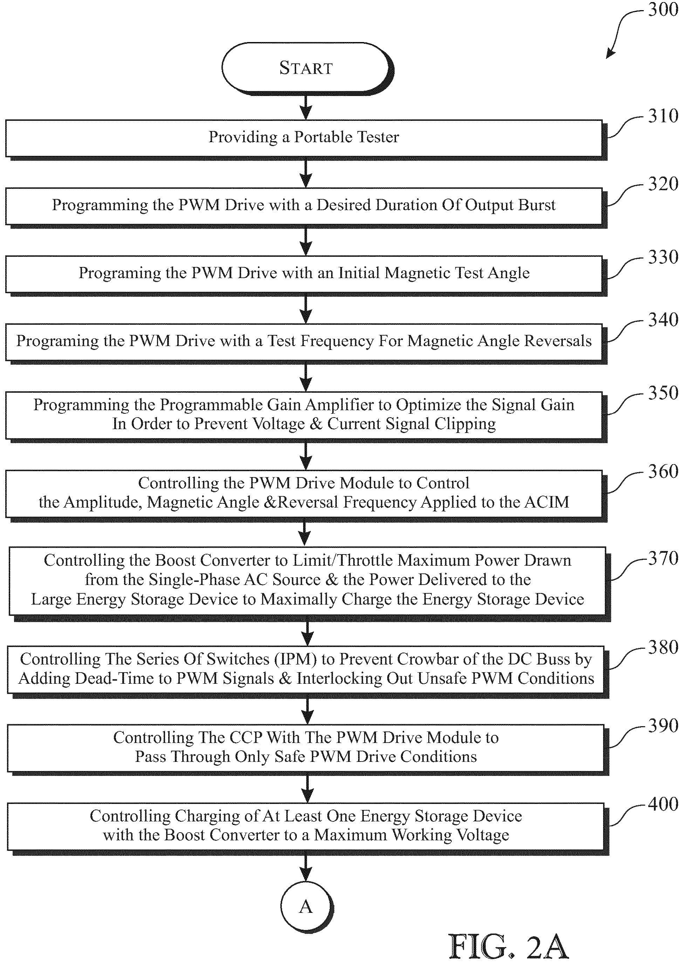

Figure 2A illustrates a first portion of a flow diagram of a method for the magnetic burst testing of large electric motors according to the system of Figure 1,

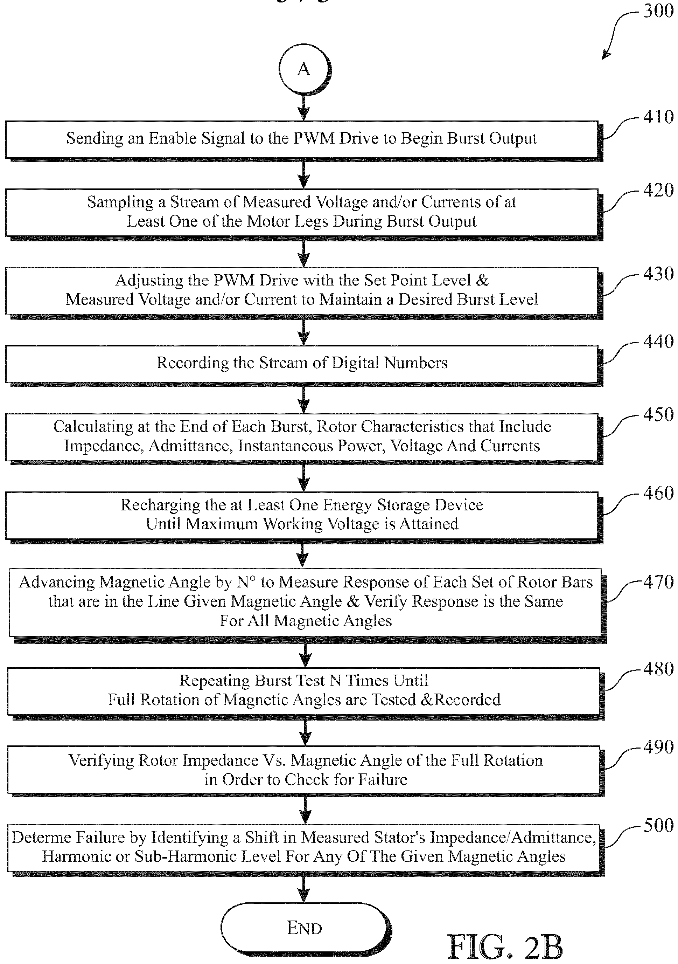

Figure 2B illustrates a continuation of the flow diagram introduced in Figure 2A with continuity provided by the continuity identifier A.

### Detailed Description of the Invention

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong. The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

### System For Magnetic Burst Testing

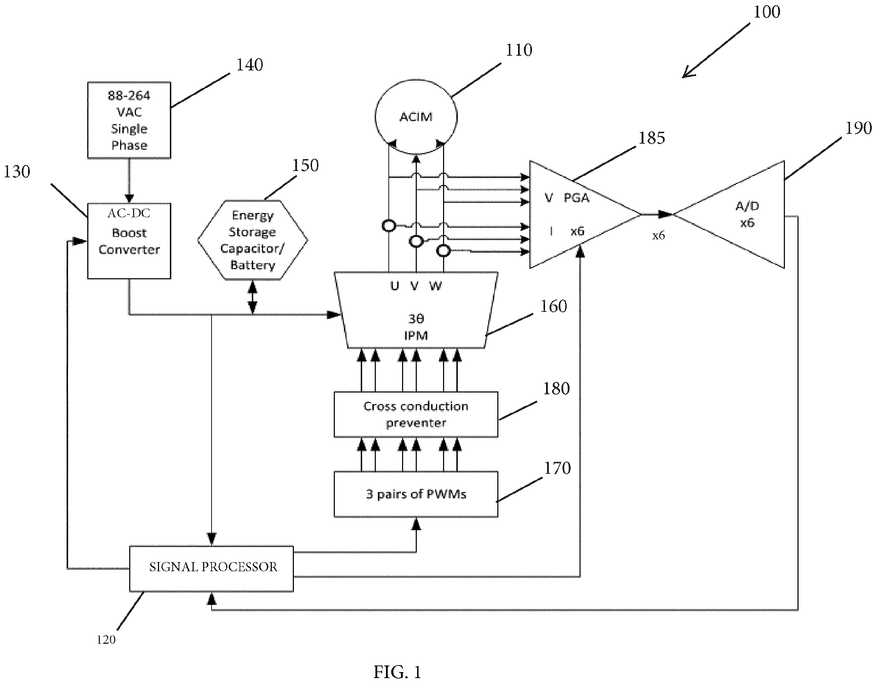

FIG. 1 shows a block diagram of a portable system 100 for the magnetic burst testing (broken rotor bar) of electric motors 110, typically large electric motors. The components shown within the system 100 are generally packaged into a relatively small, portable testing unit (actual unit not shown) that can be easily transported to an equipment site. The large electric motors to be burst tested are typically AC induction motors (ACIM's) 110 that are difficult to move. Thus, the portable system 100 of the present invention provides an advantage to the industry for testing large stationary ACIM's 110 and an advantage where the test site only has an ordinary single-phase domestic power outlet of just 117/120 Volts, negating the need for a two or three phase outlet of 220V or higher and the associated specialized multi-phase high current 'industrial' extension cord needed to connect the tester to the two or three phase industrial power outlet.

The system 100 may further provide an input power source 140 that is connected to an AC to DC Boost Converter 130. The input power source 140 is typically a single-phase AC power source at line voltage or 110-115 VAC. The AC to DC Boost Converter 130 is connected to at least one energy storage device 150. The power source 140 may alternately be a battery 140 suitable for use in the application. That is, a battery 140 having the capacity to repeatedly charge the energy storage device 150 until a maximum working voltage is maintained. Once the maximum working voltage for the energy storage device has been reached, the IPM 160 can simultaneously draw power from both the energy storage device 150 and the boost converter 130 to supply a power burst up to 8KW for testing a magnetic angle. This enables one to test all classes of medium voltage ACIM's. The energy storage device 150 may need to be recharged to the maximum working voltage multiple times during a set of tests for broken rotor bar defect. As such, the battery capacity is configured to handle this required load energy for multiple recharges.

Adding an AC to DC Boost Converter 130 to the at least one energy storage device 150 enables higher DC bus link voltage operation at lower AC line voltages and increases the stored energy in the energy storage device 150. One type of energy storage device 150 could be a DC Bus Link Capacitor 150. Alternately, a high discharge rate battery 150 may provide a suitable energy storage device 150 for purposes of the invention.

The stored energy in the Bus Link Capacitor is determined by the basic equation E = 1/2 C^{∗}(V)^2. So for example, adding the AC to DC Boost Converter to the DC bus link capacitor enables higher DC bus link voltage operation at lower AC line voltages and increases the stored energy in bus link capacitor. Consequently, with the ability to store more energy in the energy storage device, larger ACIM's can be tested using a momentary current burst test at a given magnetic angle.

By increasing the DC bus link capacitor voltage with the boost converter, the voltage margin to drive the necessary test current through the motor can be provided as the energy is drained from the dc bus capacitor during a burst test. The duty cycle of the drive PWM can be adjusted to maintain constant motor drive test current as the energy is drained from the DC bus link during the burst test of a given magnetic test angle. The power provided by a 20A 110V outlet supplemented by the stored energy in the DC bus link capacitor enables sufficient current [typically 5-10]% of nameplate current through the motor for a momentary burst to detect broken rotor bars in ACIM's.

The at least one energy storage device 150 may be connected to an Intelligent Power Module (IPM) 160. The IPM 160 may be a bundle of fixed power switches that are connected to the 3 legs of the ACIM 110. In addition, the IPM 160 may include a Cross-Conduction Preventer 180 as well as high and low side drivers for each power switch, isolated power converters for internal components, fault detection circuitry as well as scaled current and voltage outputs for each output leg (U,V,W) that could be connected to a Programmable Gain Amplifier (PGA) PGA 185. In addition to being connected to the ACIM, the IPM 160 may be connected to the Programmable Gain Amplifier (PGA) 185 either by additional current sense resistors and voltage dividers inserted on each leg U,V and W or by scaled/conditioned current and voltage outputs provided by the IPM 160.

The programmable-gain amplifier (PGA) 185 is an electronic amplifier (typically an operational amplifier) whose gain can be controlled by external digital or analog signals. In an example, the PGA 185 receives both voltage and current signals being fed by the IPM 160 to the ACIM. The PGA 185 adds gain to the signal before entering into an A/D converter 190. The A/D converter 190 provides an input that is fixed in range. Therefore, the PGA 185 may be required in order to boost gain for single level compensation depending on the size and power requirements of the ACIM to be tested and the range and resolution of the chosen A/D 190.

A pulse width modulated drive module (PWM) 170 may be connected to a series of at least three switches in the (IPM) 160 using switch/level boost-type PWM rectification. The amplitude of the 3 pairs of PWMs 170 may be programmed by the DSP for a given magnetic angle N with the U channel set to sin(N), V set to sin(N+120) and W set to (N+240). During the Burst test for each magnetic angle, the DSP may reverse the U,W and V amplitudes at a given reversal frequency either by applying a [1,-1] amplitude modifier or sinusoidal amplitude modifier at the reversal frequency rate. The IPM may be connected to both the (3) legs of the ACIM 110 and the PWM 170. The PWM 170 is connected to the IPM 160 through a Cross Conduction Preventer (CCP) 180. The CCP 180 may be provided as a safety. It may prevent severe damage to the system 100 if the PWM 170 is programmed incorrectly. The cross-conduction preventer may ensure that each set of switches in the IPM forming a half-bridge converter have sufficient dead-time added to the PWM signals to prevent cross-conduction of the half-bridge converter switches. The dead-time added may depends upon the storage time characteristics of the particular device [FET, IGBT, GTO, etc.] implemented in the IPM 160. This "dead time" must be of sufficient duration to ensure that the "on" states of the two power switches do not overlap under any conditions.

A Signal Processor 120 may be provided in order to control the function of system 100. The Signal Processor 120 may control both the PWM 170 and AC to DC Boost Converter 130 based on feedback received from the A/D converter 190 and from the energy storage device 150. The function of the Signal Processor may be provided by a single dedicated processor, by a single shared processor, or by a plurality of individual processors, some of which or all of which may be shared.

However, the term "processor" or "controller" is by far not limited to hardware exclusively capable of executing software, but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

In order to carry out the function of the system, the PWM may be programmed with a desired duration of output burst by the Signal Processor. The desired duration programmed into the PWM depends on the size and power requirements of the ACIM to be tested. The PWM may be further programmed with an initial magnetic test angle by the Signal Processor and with a test frequency for magnetic angle reversals by the Signal Processor. The test frequency for magnetic angle reversals is preferably in the range from 1Hz to 10,000 Hz. The test frequency may include a large range because it depends on iron depth penetration of the magnetic field, which varies with the size of ACIM. The magnetic field of a lower reversal test frequency penetrates deeper into the iron of a rotor whereas a higher reversal test frequency only affects the top surface of a rotor much as the 'skin depth' penetration of a RF field decreases with increasing frequency.

The PGA may be programmed by the Signal Processor to optimize the signal gain in order to prevent voltage and current signal clipping. In addition, the PGA gain may improve or optimize the signal to noise ratio of the signal and reduce quantization artifacts. The PWM may be controlled by the Signal Processor to control the amplitude, magnetic angle and reversal frequency applied to the ACIM. In addition, the boost converter is controlled with the Signal Processor to limit/throttle the maximum power drawn from the single-phase AC source/battery 140 and the power delivered to the large energy storage device 150 to maximally charge the energy storage device.

The series of switches in the IPM may be controlled with the CCP to prevent crowbar of the DC Buss by adding dead-time to the PWM signals and interlocking out unsafe PWM conditions. The CCP may be controlled with the PWM drive module to pass through only safe PWM drive conditions. The charging of the at least one energy storage device may be controlled by the boost converter to obtain a maximum working voltage.

In an example, an enable signal from the Signal Processor is first sent to the PWM drive to begin burst output from the Signal Processor. Then, a stream of measured voltage and/or currents of at least one of the motor legs during burst output with a voltage transducer and a current transducer respectively are sampled. The sampled stream is converted from an analog measured value to a digital number within the A/D Converter. A resistive voltage divider network placed on each motor leg may be provided to scale down the burst test voltage to a level that an analog to digital converter can sample using the Signal Processor. A series resistor, hall effect device or current transformer placed on each motor leg may be provided to convert the test current to a proportional voltage that an analog to digital converter can sample using the Signal Processor.

The PWM drive may be adjusted with a set point level and measured voltage and/or current to maintain a desired burst level. This is essentially an electrical feedback loop that is used to push the output drive to a desired set-point in order to compensate for sinking voltage of the at least one energy storage device 150 applied to the programmed voltage and/or current level applied to the motor with the Signal Processor 120. The stream of digital numbers is then recorded within the Signal Processor.

The stimulus burst applied to the stator coil of the ACIM may be magnetically coupled to the rotor coil. The response of the rotor coil to the stimulus burst may then be recorded as previously disclosed. There is a short transient response thereafter that dies out in about 2 ½ cycles. This is followed by a steady state response of the rotor to the burst pulse. Here, after the transient dies out the system then focuses on the steady state response.

At the end of each burst, rotor characteristics that include impedance, admittance, instantaneous power (I squared r), voltage and currents for the previously applied magnetic test angle may be calculated within the Signal Processor. The at least one energy storage device may be recharged by the boost converter until the maximum working voltage is attained once again. The Signal Processor may advance the magnetic angle by N degrees to measure the response of each set of rotor bars that are in the line given magnetic angle and verify that the response is the same for all magnetic angles. The Signal Processor may repeat the burst test by N number of times until a full rotation of magnetic angles are tested and recorded in a memory within the Signal Processor.

In an example, the Signal Processor verifies rotor impedance versus magnetic angle of the full rotation in order to check for failure. Broken rotor bar defect is determined when a shift in measured stator's impedance/admittance (Resistance and inductance), for any of the given magnetic angles is identified by the Signal Processor. In an alternate embodiment, the recorded voltage and current samples used to calculate the response of the rotor bars stimulated by the burst pulse for the given magnetic angle setting, may provide harmonic or sub-harmonic level harmonics, pulsation, etc. That is, not only impedance could be verified, but for intermittently connected rotor bar as well

By rotating the magnetic field, different rotor bar sets may be probed. A response of a good rotor bar set responding to a burst pulse at one magnetic field angle simulating them is identified as being different than that of broken rotor bar set probed with the magnetic angle burst pulse that stimulates them instead. Consequently, it is clear that different responses are obtained between a good rotor bar response versus a bad rotor bar response.

Further, if the response for a given magnetic angle is different than all the other measured magnetic angles, then the construction of the rotor is not symmetrical. As such, a failure in one of the rotor bar sets probed by the magnetic angle is shown by the deviation from the normalized measurements. Consequently, rotor porosity problems could also be detected.

In addition to the transformer coupled impedance of the rotor as measured by the stator, the harmonics and sub-harmonic response of the rotor to the burst may be measured. Here, the magnetic angle of the burst pulse is rotated to probe the rotor bars that the magnetic field passes through. Consequently, additional harmonics and sub-harmonic response can be beneficial in determining faults.

### Method For Magnetic Burst Testing

A method 300 for magnetic/impedance burst testing of electric motors, typically large electric motors, will now be disclosed. In an example, the method 300 includes providing 310 the portable tester having the Signal Processor, the single-phase power source VAC, the AC to DC boost converter connected to the power source, at least one energy storage device connected to the AC to DC boost converter, the pulse width modulated drive (PWM) module connected to the at least one energy storage device, and the series of at least three switches (IPM) using switch/level boost-type PWM rectification, the IPM being connected to both the 3 legs of the large electric motor and the PWM drive.

The method may further provide the following programming steps that are required in order to carry out the method. They may include a step of programming the PWM drive 320 with a desired duration of output burst, programing the PWM drive 330 with an initial magnetic test angle, programing the PWM drive 340 with a test frequency for magnetic angle reversals, and programming the Programmable Gain Amplifier 350 to optimize the signal gain in order to prevent voltage and current signal clipping. All of the aforementioned programming steps are carried out by the Signal Processor.

The method may provide the following controlling steps that are required to control the method. They may include a step of controlling the PWM drive module 360 to control the amplitude, magnetic angle and reversal frequency applied to the ACIM, controlling the boost converter 370 with the Signal Processor to limit/throttle the maximum power drawn from the single-phase AC source and the power delivered to the large energy storage device to maximally charge the energy storage device, controlling the series of switches (IPM) 380 with the CCP to prevent crowbar of the DC Buss by adding dead-time to the PWM signals and interlocking out unsafe PWM conditions, controlling the CCP 390 with the PWM drive module to pass through only safe PWM drive conditions, and controlling the charging of the at least one energy storage device 400 with the boost converter to a maximum working voltage.

The method may then provide a step of sending an enable signal 410 to the PWM drive to begin burst output from the Signal Processor. Further, a step of sampling a stream of measured voltage and/or currents of at least one of the motor legs 420 during burst output with the voltage transducer and the current transducer respectively may be provided. This converts from the analog to the digital A/D Converter digital number with the A/D Converter. Next, a step of adjusting 430 the PWM drive with the set point level and measured voltage and/or current to maintain a desired burst level (electrical feedback loop to push the output drive to a desired set-point) in order to compensate for sinking voltage of the at least one energy storage device applied to the programmed voltage and/or current level applied to the motor with the Signal Processor may be carried out. A step of recording the stream of digital numbers 440 with the Signal Processor may be carried out.

The method may include calculating, at the end of each burst, rotor characteristics 450 that may include impedance, admittance, instantaneous power, voltage and currents for the previously applied magnetic test angle with the Signal Processor,

Subsequently, a step of recharging 460 the at least one energy storage device with the boost converter until the maximum working voltage is attained may be then undertaken. In step 470, advancing the magnetic angle by N degrees to measure the response of each set of rotor bars that are in the line given magnetic angle and verify the response is the same for all magnetic angles with the Signal Processor may be started. In step 480, repeating the burst test N number of times until a full rotation of magnetic angles are tested and recorded with the Signal Processor may be started.

In step 490 verifying, with the Signal Processor, rotor impedance versus magnetic angle of the full rotation in order to check for failure may be initiated, and finally, in step 500 determining failure by identifying a shift in measured stator's impedance/admittance, harmonic or sub-harmonic level for any of the given magnetic angles is accomplished by the Signal Processor. A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

Furthermore, the following claims are hereby incorporated into the detailed description, where each claim may stand on its own as a separate example.

## Claims

1. A method for magnetic/impedance burst testing of an AC induction motor (110), i.e. ACIM, comprising:
providing a portable tester that provides a Signal Processor (120), a single-phase power source VAC (140), an AC to DC boost converter (130) connected to the power source, at least one energy storage device (150) connected to the AC to DC boost converter (130), a pulse width modulated drive module (170) connected to the at least one energy storage device (150), and a series of at least three switches (160), i.e. IPM, using switch/level boost-type pulse width modulated rectification, the IPM connected to both the 3 legs of the large electric motor and the pulse width modulated drive module (170), the method comprising:
programming the pulse width modulated drive module (170) with a desired duration of output burst with the Signal Processor (120);
programming the pulse width modulated drive module (170) with an initial magnetic test angle with the Signal Processor (120);
programming the pulse width modulated drive module (170) with a test frequency for magnetic angle reversals with the Signal Processor (120);
programming a Programmable Gain Amplifier (185) with the Signal Processor to optimize the signal gain in order to prevent voltage and current signal clipping; and
controlling the pulse width modulated drive module (170) with the Signal Processor (120) to control the amplitude, magnetic angle and test frequency for magnetic angle reversals applied to the ACIM.

2. A method according to claim 1, comprising:
controlling the boost converter (130) with the Signal Processor (120) to limit/throttle the maximum power drawn from the single-phase AC source (140) and the power delivered to the large energy storage device (150) to maximally charge the energy storage device (150).

3. A method according to claim 1 or claim 2, comprising controlling the series of switches (160), i.e IPM, with a Cross Conduction Preventer (180), i.e. CCP, to prevent crowbar of a DC Bus by adding dead-time to the pulse width modulated signals and interlocking out unsafe pulse width modulated conditions, and
controlling the CCP (180) with the pulse width modulated drive module (170) to pass through only safe pulse width modulated conditions.

4. A method according to any preceding claim, comprising controlling the charging of the at least one energy storage device (150) with the boost converter (130) to a maximum working voltage,
sending an enable signal to the pulse width modulated drive module (170) to begin burst output from the Signal Processor (120), and
sampling a stream of measured voltage and/or currents of at least one of the motor legs during burst output with a voltage transducer and/or a current transducer respectively, which converts from analog to a digital A/D Converter digital number with the A/D Converter.

5. A method according to claim 4, comprising adjusting the pulse width modulated drive module (170) with a set point level and measured voltage and/or current to maintain a desired burst level in order to compensate for sinking voltage of the at least one energy storage device (150) applied to the programmed voltage and/or current level applied to the motor (110) with the Signal Processor (120):
recording a stream of digital numbers with the Signal Processor (120); and
calculating, at the end of each burst, rotor characteristics that include impedance, admittance, instantaneous power, voltage and currents for the previously applied magnetic test angle with the Signal Processor (120).

6. A method according to any preceding claim, comprising:
recharging the at least one energy storage device (150) with the boost converter (130) until the maximum working voltage is attained,
advancing the magnetic angle by N degrees to measure a response of each set of rotor bars that are in the line given magnetic angle and verify the response is the same for all magnetic angles with the Signal Processor (120),
repeating a burst test N number of times until a full rotation of magnetic angles are tested and recorded with the Signal Processor (120),
verifying, with the Signal Processor (120), rotor impedance versus magnetic angle of the full rotation in order to check for failure, and
determining failure by identifying a shift in measured stator's impedance/admittance, harmonic or sub-harmonic level for any of the given magnetic angles by the Signal Processor (120).

7. A system, for magnetic/impedance burst testing of an AC induction motor (110), i.e. ACIM, configured to determine broken rotor bar defect, the system being encased in a portable tester and comprising:
a Signal Processor (120);
a single-phase power source (140) VAC;
an AC to DC boost converter (130) connected to the power source (140);
at least one energy storage device (150) connected to the AC to DC boost converter (130);
a Pulse Width Modulated drive module (170) connected to the at least one energy storage device; and
a series of at least three switches (160), i.e IPM, the system being configured such that the IPM uses switch/level boost-type pulse width modulated rectification, the IPM (160) connected to both the 3 legs of the large electric motor (110) and the pulse width modulated drive module (170), wherein
the pulse width modulated drive module (170) is programmed with a desired duration of output burst by the Signal Processor (120);
the pulse width modulated drive module (170) is programmed with an initial magnetic test angle by the Signal Processor (120), the pulse width modulated drive module (170) is programmed with a test frequency for magnetic angle reversals by the Signal Processor (120);
a programmable Gain Amplifier (185) is programmed by the Signal Processor (120) to optimize the signal gain in order to prevent voltage and current signal clipping; and
the pulse width modulated drive module (170) is controlled by the Signal Processor (120) to control the amplitude, magnetic angle and test frequency for magnetic angle reversals applied to the ACIM (110).

8. A system according to claim 7, configured such that:
the boost converter (130) is controlled by the Signal Processor (120) to limit/throttle the maximum power drawn from the single-phase AC source (140) and the power delivered to the large energy storage device (150) to maximally charge the energy storage device (150).

9. A system according to claim 7 or claim 8, configured such that
the series of switches IPM (160) is controlled by a Cross Conduction Preventer (180), i.e. CCP, to prevent crowbar of a DC Bus by adding dead-time to the pulse width modulated signals and interlocking out unsafe pulse width modulated conditions,
the CCP (180) is controlled by the pulse width modulated drive module (170) to pass through only safe pulse width modulated conditions.

10. A system according to any one of claims 7 to 9, configured such that:
the charging of the at least one energy storage device (150) is controlled by the boost converter (130) to a maximum working voltage;
an enable signal to the pulse width modulated drive module (170) to begin burst output is sent from the Signal Processor (120); and
a stream of measured voltage and/or currents of at least one of the motor legs during burst output are sampled with at least one voltage transducer and/or at least one current transducer respectively, which converts from analog to a digital A/D Converter digital number with an A/D Converter (190).

11. A system according to claim 10, configured such that :
the pulse width modulated drive module (170) is adjusted with a set point level and measured voltage and/or current to maintain a desired burst level in order to compensate for sinking voltage of the at least one energy storage device (150) applied to the programmed voltage and/or current level applied to the large electric motor (110) with the Signal Processor (120),
a stream of digital numbers is stored within the Signal Processor (120),
at the end of each burst, rotor characteristics that include impedance, admittance, instantaneous power, i.e.I squared r, voltage and currents for the previously applied magnetic test angle are calculated by the Signal Processor (120).

12. A system according to any one of claims 7 to 11, configured such that
the at least one energy storage device (150) is recharged by the boost converter (130) until the maximum working voltage is re-attained;
the magnetic angle is advanced by N degrees to measure a response of each set of rotor bars that are in the line given magnetic angle and verify the response is the same for all magnetic angles with the Signal Processor (120);
a burst test is repeated N number of times until a full rotation of magnetic angles are tested and recorded with the Signal Processor (120);
the Signal Processor (120) is configured to verify the rotor impedance versus magnetic angle of the full rotation in order to check for failure, and wherein
broken rotor bar defect is determined when a shift in measured stator's impedance/admittance, harmonic or sub-harmonic level for any of the given magnetic angles is identified by the Signal Processor (120).

## Patentansprüche

1. Verfahren zum Magnet-/Impedanz-Burst-Testen eines Wechselstromasynchronmotors (110), d. h. ACIM, umfassend:
Bereitstellen eines tragbaren Prüfgeräts, das einen Signalprozessor (120), eine einphasige Energiequelle VAC (140), einen Wechselstrom-zu-Gleichstrom-Aufwärtswandler (130), der mit der Energiequelle verbunden ist, mindestens eine Energiespeichervorrichtung (150), die mit dem Wechselstrom-zu-Gleichstrom-Aufwärtswandler (130) verbunden ist, ein pulsweitenmoduliertes Treibermodul (170), das mit der mindestens einen Energiespeichervorrichtung (150) verbunden ist, und eine Reihe von mindestens drei Schaltern (160), d. h. IPM, der eine pulsweitenmodulierte Gleichrichtung vom Schalter/Pegelanhebungstyp verwendet, bereitstellt, wobei der IPM mit beiden der drei Zweige des großen elektrischen Motors und dem pulsweitenmodulierten Treibermodul (170) verbunden ist, wobei das Verfahren umfasst:
Programmieren des pulsweitenmodulierten Treibermoduls (170) mit einer gewünschten Dauer einer Ausgabe eines Bursts mit dem Signalprozessor (120);
Programmieren des pulsweitenmodulierten Treibermoduls (170) mit einem initialen magnetischen Testwinkel mit dem Signalprozessor (120);
Programmieren des pulsweitenmodulierten Treibermoduls (170) mit einer Testfrequenz für magnetische Winkelumkehrungen mit dem Signalprozessor (120);
Programmieren eines programmierbaren Verstärkungsverstärkers (185) mit dem Signalprozessor zum Optimieren der Signalverstärkung, um eine Spannungs- und Stromsignalkappung zu verhindern; und
Steuern des pulsweitenmodulierten Treibermoduls (170) mit dem Signalprozessor (120) zum Steuern der Amplitude, des magnetischen Winkels und der Testfrequenz für magnetische Winkelumkehrungen, die auf den ACIM angewendet werden.

2. Verfahren nach Anspruch 1, umfassend:
Steuern des Aufwärtswandlers (130) mit dem Signalprozessor (120) zur Begrenzung/Drosselung der maximalen Energie, die von der einphasigen Wechselstromquelle (140) bezogen wird, und der Energie, die zur großen Energiespeichervorrichtung (150) geliefert wird, um die Energiespeichervorrichtung (150) maximal zu laden.

3. Verfahren nach Anspruch 1 oder Anspruch 2, umfassend ein Steuern der Reihe von Schaltern (160), d. h. IPM, mit einem Kreuz-Leitungsverhinderer (180), d.h. CCP, um eine Überspannung eines Gleichstrombusses durch Hinzufügen von Totzeiten zu den pulsweitenmodulierten Signalen und Aussperren unsicherer pulsweitenmodulierter Bedingungen zu verhindern, und
Steuern des CCP (180) mit dem pulsweitenmodulierten Treibermodul (170), um nur sichere pulsweitenmodulierte Bedingungen durchzulassen.

4. Verfahren nach einem der vorhergehenden Ansprüche, umfassend ein Steuern des Ladens der mindestens einen Energiespeichervorrichtung (150) mit dem Aufwärtswandler (130) auf eine maximale Betriebsspannung,
Senden eines Aktivierungssignals an das pulsweitenmodulierte Treibermodul (170) vom Signalprozessor (120), um eine Burst Ausgabe zu beginnen, und
Abtasten eines Stroms gemessener Spannungen und/oder Ströme mindestens eines der Motorzweige während der Burst Ausgabe entsprechend mit einem Spannungswandler und/oder einem Stromwandler, der von analog zu einer digitalen A/D-Wandler-digital-Nummer mit dem A/D-Wandler wandelt.

5. Verfahren nach Anspruch 4, umfassend ein Einstellen des pulsweitenmodulierten Treibermoduls (170) mit einem Sollwertpegel und gemessener Spannung und/oder Strom zum Aufrechterhalten eines gewünschten Burstpegels zur Kompensation einer sinkenden Spannung der mindestens einen Energiespeichervorrichtung (150), angewendet auf den programmierten Spannungs- und/oder Strompegel, der an den Motor (110) angelegt wird, mit dem Signalprozessor (120):
Aufnehmen eines Stroms von digitalen Nummern mit dem Signalprozessor (120); und
Berechnen von Rotorcharakteristiken am Ende jedes Bursts, die eine Impedanz, Admittanz, Momentanleistung, Spannung und Ströme für die zuvor angewendeten magnetischen Testwinkel (120) umfassen, mit dem Signalprozessor.

6. Verfahren nach einem der vorhergehenden Ansprüche, umfassend:
Wiederaufladen der mindestens einen Energiespeichervorrichtung (150) mit dem Aufwärtswandler (130) bis die maximale Betriebsspannung erreicht ist,
Vorverlagerung des magnetischen Winkels durch N Grad zum Messen einer Reaktion jedes Satzes von Rotorstäben, die in der Linie eines gegebenen magnetischen Winkels liegen, und Verifizieren, dass die Reaktion die gleiche für alle magnetischen Winkel ist, mit dem Signalprozessor (120),
Wiederholen eines Burst-Tests mit N-maligem Wiederholen, bis eine volle Rotation von magnetischen Winkeln mit dem Signalprozessor (120) getestet und aufgenommen wurden,
Verifizieren einer Rotorimpedanz gegenüber einem magnetischen Winkel der vollen Rotation zur Fehlerüberprüfung mit dem Signalprozessor (120), und
Bestimmen eines Fehlers durch Identifizieren eines Versatzes in einer gemessenen Statorimpedanz/-admittanz, einem harmonischen oder subharmonischen Pegel für jeden der gegebenen magnetischen Winkel durch den Signalprozessor (120).

7. System zum Magnet-/Impedanz-Burst-Testen eines Wechselstromasynchronmotors (110), d. h. ACIM, das eingerichtet ist, um einen Defekt eines gebrochenen Rotorstabs zu bestimmen, wobei das System in einem tragbaren Prüfgerät eingeschlossen ist und umfasst:
einen Signalprozessor (120);
eine einphasige Energiequelle (140) VAC;
einen Wechselstrom-zu-Gleichstrom-Aufwärtswandler (130), der mit der Energiequelle (140) verbunden ist;
mindestens eine Energiespeichervorrichtung (150), die mit dem Wechselstrom-zu-Gleichstrom-Aufwärtswandler (130) verbunden ist;
ein pulsweitenmoduliertes Treibermodul (170), das mit der mindestens einen Energiespeichervorrichtung verbunden ist; und
eine Reihe von mindestens drei Schaltern (160), d. h. IPM, wobei das System eingerichtet ist, so dass der IPM eine pulsweitenmodulierte Gleichrichtung vom Schalter/Pegelanhebungstyp verwendet, wobei der IPM (160) mit beiden der drei Zweige des großen elektrischen Motors (110) und dem pulsweitenmodulierten Treibermodul (170) verbunden ist, wobei
das pulsweitenmodulierte Treibermodul (170) mit einer gewünschten Dauer einer Ausgabe eines Bursts durch den Signalprozessor (120) programmiert ist;
das pulsweitenmodulierte Treibermodul (170) mit einem initialen magnetischen Testwinkel durch den Signalprozessor (120) programmiert ist, das pulsweitenmodulierte Antriebsmodul (170) mit einer Testfrequenz für magnetische Winkelumkehrungen durch den Signalprozessor (120) programmiert ist;
ein programmierbarer Verstärkungsverstärker (185) durch den Signalprozessor (120) zum Optimieren der Signalverstärkung programmiert ist, um eine Spannungs- und Stromsignalkappung zu verhindern; und
das pulsweitenmodulierte Treibermodul (170) durch den Signalprozessor (120) gesteuert wird zum Steuern der Amplitude, des magnetischen Winkels und der Testfrequenz für magnetische Winkelumkehrungen, die auf die ACIM (110) angewendet werden.

8. System nach Anspruch 7, eingerichtet, so dass:
der Aufwärtswandler (130) durch den Signalprozessor (120) gesteuert wird, um die maximale Energie, die von der einphasigen-Wechselstromquelle (140) bezogen wird, und die Energie, die an die große Energiespeichervorrichtung (150) geliefert wird, zu limitieren/drosseln, um die Energiespeichervorrichtung (150) maximal zu laden.

9. System nach Anspruch 7 oder 8, eingerichtet, so dass:
die Reihe von Schaltern IPM (160) durch einen Kreuz-Leitungsverhinderer (180), d. h. CCP, gesteuert wird, um eine Überspannung eines Gleichstrombusses durch Hinzufügen von Totzeit zu den pulsweitenmodulierten Signalen und Aussperren unsicherer pulsweitenmodulierter Bedingungen zu verhindern,
der CCP (180) durch das pulsweitenmodulierte Treibermodul (170) gesteuert wird, um nur sichere pulsweitenmodulierte Bedingungen durchzulassen.

10. System nach einem der Ansprüche 7 bis 9, eingerichtet, so dass:
das Laden der mindestens einen Energiespeichervorrichtung (150) durch den Aufwärtswandler (130) auf eine maximale Betriebsspannung gesteuert wird;
ein Aktivierungssignal zum pulsweitenmodulierten Treibermodul (170) vom Signalprozessor (120) gesendet wird, um eine Burst Ausgabe zu beginnen; und
ein Strom von gemessenen Spannungen und/oder Strömen mindestens eines der Motorzweige während der Burst Ausgabe entsprechend mit mindestens einem Spannungswandler und/oder mindestens einem Stromwandler abgetastet wird, der von analog zu einer digitalen A/D-Wandler-Digital-Nummer mit einem A/D-Wandler (190) wandelt.

11. System nach Anspruch 10, eingerichtet, so dass:
das pulsweitenmodulierte Treibermodul (170) mit einem Sollwertpegel und gemessener Spannung und/oder Strom eingestellt wird, um einen gewünschten Burstpegel aufrechtzuerhalten, um eine sinkende Spannung der mindestens einen Energiespeichervorrichtung (150) zu kompensieren, angewendet auf den programmierten Spannungs- und/oder Strompegel, der auf den großen elektrischen Motor (110) angelegt wird, mit dem Signalprozessor (120),
ein Strom von digitalen Nummern innerhalb des Signalprozessors (120) gespeichert wird,
am Ende jedes Bursts, Rotorcharakteristiken, die eine Impedanz, Admittanz, Momentanleistung, d. h. I Quadrat r, Spannung und Ströme für die zuvor angewendeten magnetischen Testwinkel durch den Signalprozessor (120) berechnet werden.

12. System nach einem der Ansprüche 7 bis 11, eingerichtet, so dass:
die mindestens eine Energiespeichervorrichtung (150) durch den Aufwärtswandler (130) bis die maximale Betriebsspannung wieder erreicht wird aufgeladen wird;
der magnetische Winkel durch N Grad vorverlagert wird, um eine Reaktion jedes Satzes von Rotorstäben, die in der Linie eines gegebenen magnetischen Winkels liegen, zu messen, und Verifizieren, dass die Reaktion die gleiche für alle magnetischen Winkel ist, mit dem Signalprozessor (120);
ein Burst-Test mit N-maligem Wiederholen wiederholt wird, bis eine volle Rotation von magnetischen Winkeln mit dem Signalprozessor (120) getestet und aufgenommen wurde;
der Signalprozessor (120) eingerichtet ist, die Rotorimpedanz gegenüber einem magnetischen Winkel der vollen Rotation zur Fehlerüberprüfung zu verifizieren, und wobei
ein Defekt eines gebrochenen Rotorstabs bestimmt wird, wenn ein Versatz einer gemessenen Statorimpedanz/-admittanz, eines harmonischen oder subharmonischen Pegels für jede der gegebenen magnetischen Winkel durch den Signalprozessor (120) identifiziert wird.

## Revendications

1. Procédé de test de salve magnétique/d'impédance d'un moteur à induction de courant alternatif (110), dit ACIM, comprenant les étapes consistant à :
fournir un testeur portable qui fournit un processeur de signal (120), une source de puissance en volt de courant alternatif monophasé (140), un convertisseur élévateur de courant alternatif en courant continu (130) connecté à la source de puissance, au moins un dispositif de stockage d'énergie (150) connecté au convertisseur élévateur de courant alternatif en courant continu (130), un module d'entraînement à modulation de largeur d'impulsion (170) connecté à l'au moins un dispositif de stockage d'énergie (150), et une série d'au moins trois commutateurs (160), dite IPM, utilisant un redressement à modulation de largeur d'impulsion du type élévation de commutation/de niveau, l'IPM étant connectée aux 3 branches du grand moteur électrique ainsi qu'au module d'entraînement à modulation de largeur d'impulsion (170), le procédé comprenant les étapes consistant à :
programmer le module d'entraînement à modulation de largeur d'impulsion (170) avec une durée souhaitée de sortie de salves avec le processeur de signal (120) ;
programmer le module d'entraînement à modulation de largeur d'impulsion (170) avec un angle de test magnétique initial avec le processeur de signal (120) ;
programmer le module d'entraînement à modulation de largeur d'impulsion (170) avec une fréquence de test pour les inversions d'angle magnétique avec le processeur de signal (120) ;
programmer un amplificateur de gain programmable (185) avec le processeur de signal pour optimiser le gain de signal afin d'empêcher l'écrêtage des signaux de tension et de courant ; et
commander le module d'entraînement à modulation de largeur d'impulsion (170) avec le processeur de signal (120) pour commander l'amplitude, l'angle magnétique et la fréquence de test pour les inversions d'angle magnétique appliqués à l'ACIM.

2. Procédé selon la revendication 1, comprenant l'étape consistant à :
commander le convertisseur élévateur (130) avec le processeur de signal (120) pour limiter/étrangler la puissance maximale tirée de la source de courant alternatif monophasé (140) et la puissance fournie au grand dispositif de stockage d'énergie (150) pour charger au maximum le dispositif de stockage d'énergie (150).

3. Procédé selon la revendication 1 ou la revendication 2, comprenant l'étape consistant à commander la série de commutateurs (160), dite IPM, avec un dispositif empêchant la conduction croisée (180), dit CCP, pour empêcher de forcer un bus à courant continu en ajoutant un temps mort aux signaux de modulation de largeur d'impulsion et en bloquant des conditions non sûres de modulation de largeur d'impulsion, et
commander le CCP (180) avec le module d'entraînement à modulation de largeur d'impulsion (170) pour ne passer que par des conditions sûres de modulation de largeur d'impulsion.

4. Procédé selon l'une quelconque des revendications précédentes, comprenant les étapes consistant à
commander la charge de l'au moins un dispositif de stockage d'énergie (150) avec le convertisseur élévateur (130) à une tension de fonctionnement maximale,
envoyer un signal d'activation destiné au module d'entraînement à modulation de largeur d'impulsion (170) pour commencer la sortie de salves à partir du processeur de signal (120), et
échantillonner un flux de tension et/ou de courants mesurés d'au moins l'une des branches de moteur pendant la sortie de salves avec un transducteur de tension et/ou un transducteur de courant respectivement, qui effectue une conversion de l'analogique en un nombre numérique de convertisseur A/N numérique avec le convertisseur A/N.

5. Procédé selon la revendication 4, comprenant les étapes consistant à régler le module d'entraînement à modulation de largeur d'impulsion (170) avec un niveau de point de consigne et une tension et/ou un courant mesurés pour maintenir un niveau de salve souhaité afin de compenser la tension d'abaissement de l'au moins un dispositif de stockage d'énergie (150) appliquée à la tension et/ou au niveau de courant programmés appliqués au au moteur (110) avec le processeur de signal (120) ;
enregistrer un flux de nombres numériques avec le processeur de signal (120) ; et
calculer, à la fin de chaque salve, des caractéristiques de rotor qui comportent l'impédance, l'admittance, la puissance instantanée, la tension et les courants pour l'angle de test magnétique précédemment appliqué avec le processeur de signal (120).

6. Procédé selon l'une quelconque des revendications précédentes, comprenant les étapes consistant à :
recharger l'au moins un dispositif de stockage d'énergie (150) avec le convertisseur élévateur (130) jusqu'à ce que la tension de fonctionnement maximale soit atteinte,
avancer l'angle magnétique de N degrés pour mesurer une réponse de chaque ensemble de barres de rotor qui se trouvent dans la ligne de l'angle magnétique donné et vérifier que la réponse soit la même pour tous les angles magnétiques avec le processeur de signal (120),
répéter un test de salve N fois jusqu'à ce qu'une rotation complète des angles magnétiques soit testée et enregistrée avec le processeur de signal (120),
vérifier, avec le processeur de signal (120), l'impédance de rotor par rapport à l'angle magnétique de la rotation complète afin de contrôler les défaillances, et
déterminer la défaillance en identifiant un décalage d'impédance/admittance de niveau harmonique ou sous-harmonique mesuré du stator pour l'un quelconque des angles magnétiques donnés par le processeur de signal (120).

7. Système, pour tester la salve magnétique/d'impédance d'un moteur à induction de courant alternatif (110), dit ACIM, configuré pour déterminer le défaut de barre de rotor brisée, le système étant encastré dans un testeur portable et comprenant :
un processeur de signal (120) ;
une source de puissance en volt de courant alternatif monophasé (140) ;
un convertisseur élévateur de courant alternatif en courant continu (130) connecté à la source de puissance (140) ;
au moins un dispositif de stockage d'énergie (150) connecté au convertisseur élévateur de courant alternatif en courant continu (130) ;
un module d'entraînement à modulation de largeur d'impulsion (170) connecté à l'au moins un dispositif de stockage d'énergie ; et
une série d'au moins trois commutateurs (160), dite IPM, le système étant configuré de sorte que l'IPM utilise un redressement à modulation de largeur d'impulsion du type élévation de commutation/de niveau, l'IPM (160) étant connectée aux 3 branches du grand moteur électrique (110) ainsi qu'au module d'entraînement à modulation de largeur d'impulsion (170), où
le module d'entraînement à modulation de largeur d'impulsion (170) est programmé avec une durée souhaitée de sortie de salves par le processeur de signal (120) ;
le module d'entraînement à modulation de largeur d'impulsion (170) est programmé avec un angle de test magnétique initial par le processeur de signal (120), le module d'entraînement à modulation de largeur d'impulsion (170) est programmé avec une fréquence de test pour les inversions d'angle magnétique par le processeur de signal (120) ;
un amplificateur de gain programmable (185) est programmé par le processeur de signal (120) pour optimiser le gain de signal afin d'empêcher l'écrêtage des signaux de tension et de courant ; et
le module d'entraînement à modulation de largeur d'impulsion (170) est commandé par le processeur de signal (120) pour commander l'amplitude, l'angle magnétique et la fréquence de test pour les inversions d'angle magnétique appliqués à l'ACIM (110).

8. Système selon la revendication 7, configuré de sorte que :
le convertisseur élévateur (130) soit commandé par le processeur de signal (120) pour limiter/étrangler la puissance maximale tirée de la source de courant alternatif monophasé (140) et la puissance fournie au grand dispositif de stockage d'énergie (150) pour charger au maximum le dispositif de stockage d'énergie (150).

9. Système selon la revendication 7 ou la revendication 8, configuré de sorte que
la série de commutateurs IPM (160) soit commandée par un dispositif empêchant la conduction croisée (180), dit CCP, pour empêcher de forcer un bus à courant continu en ajoutant un temps mort aux signaux de modulation de largeur d'impulsion et en bloquant des conditions non sûres de modulation de largeur d'impulsion,
le CCP (180) est commandé par le module d'entraînement à modulation de largeur d'impulsion (170) pour ne passer que par des conditions sûres de modulation de largeur d'impulsion.

10. Système selon l'une quelconque des revendications 7 à 9, configuré de sorte que
la charge de l'au moins un dispositif de stockage d'énergie (150) soit commandée par le convertisseur élévateur (130) à une tension de fonctionnement maximale ;
un signal d'activation destiné au module d'entraînement à modulation de largeur d'impulsion (170) pour commencer la sortie de salves soit envoyé à partir du processeur de signal (120) ; et
un flux de tension et/ou de courants mesurés d'au moins l'une des branches de moteur pendant la sortie de salves soit échantillonné avec au moins un transducteur de tension et/ou au moins un transducteur de courant respectivement, qui effectue une conversion de l'analogique en un nombre numérique de convertisseur A/N numérique avec un convertisseur A/N (190).

11. Système selon la revendication 10, configuré de sorte que le module d'entraînement à modulation de largeur d'impulsion (170) soit réglé avec un niveau de point de consigne et une tension et/ou un courant mesurés pour maintenir un niveau de salve souhaité afin de compenser la tension d'abaissement de l'au moins un dispositif de stockage d'énergie (150) appliquée à la tension et/ou au niveau de courant programmés appliqués au grand moteur électrique (110) avec le processeur de signal (120),
un flux de nombres numériques est stocké dans le processeur de signal (120),
à la fin de chaque salve, des caractéristiques de rotor qui comportent l'impédance, l'admittance, la puissance instantanée, c'est-à-dire r au carré de I, la tension et les courants pour l'angle de test magnétique précédemment appliqué sont calculées par le processeur de signal (120).

12. Système selon l'une quelconque des revendications 7 à 11, configuré de sorte que :
l'au moins un dispositif de stockage d'énergie (150) soit rechargé par le convertisseur élévateur (130) jusqu'à ce que la tension de fonctionnement maximale soit atteinte de nouveau ;
l'angle magnétique soit avancé de N degrés pour mesurer une réponse de chaque ensemble de barres de rotor qui se trouvent dans la ligne de l'angle magnétique donné et vérifier que la réponse soit la même pour tous les angles magnétiques avec le processeur de signal (120) ;
un test de salve soit répété N fois jusqu'à ce qu'une rotation complète des angles magnétiques soit testée et enregistrée avec le processeur de signal (120) ;
le processeur de signal (120) soit configuré pour vérifier l'impédance de rotor par rapport à l'angle magnétique de la rotation complète afin de contrôler les défaillances, et où
un défaut de barre de rotor brisée est déterminé lorsqu'un décalage d'impédance/admittance de niveau harmonique ou sous-harmonique mesuré du stator pour l'un quelconque des angles magnétiques donnés est identifié par le processeur de signal (120).
